(19) Europäisches Patentamt
European Patent Office
Office européen des brevets

(11) Publication number: **0 421 195 A2**

(12) # EUROPEAN PATENT APPLICATION

(21) Application number: **90118070.3**

(51) Int. Cl.[5]: **G03F 7/038**

(22) Date of filing: **20.09.90**

(30) Priority: **22.09.89 US 409482**

(43) Date of publication of application:
**10.04.91 Bulletin 91/15**

(84) Designated Contracting States:
**AT CH DE FR GB IT LI NL**

(71) Applicant: **E.I. DU PONT DE NEMOURS AND COMPANY**
**1007 Market Street**
**Wilmington Delaware 19898(US)**

(72) Inventor: **Nader, Allan E.**
**328 Snuff Mill Road**
**Wilmington, Delaware 19807(US)**
Inventor: **Pottiger, Michael T.**
**141 S. King's Croft Drive**
**Bear, Delaware 19701(US)**

(74) Representative: **von Kreisler, Alek, Dipl.-Chem. et al**
**Patentanwälte Von Kreisler-Selting-Werner, Deichmannhaus am Hauptbahnhof**
**W-5000 Köln 1(DE)**

(54) **Photoreactive resin compositions developable in a semi-aqueous solution.**

(57) This invention concerns a photosensitive polymer composition that can be developed using an aqueous alkaline developer solution. The photosensitive polymer composition is useful for forming relief structures on electrical devices.

EP 0 421 195 A2

# PHOTOREACTIVE RESIN COMPOSITIONS DEVELOPABLE IN A SEMI-AQUEOUS SOLUTION

## BACKGROUND OF THE INVENTION

Polyimides and other resins have been receiving considerable attention from the microelectronics industry because of their high thermal and chemical stability, low dielectric constants, and excellent planarization capabilities. Applications for these resins include surface-protective films (for example passivation layers, alpha-protection barriers, etc.), interlayer dielectrics on integrated circuits and multilayer thin-film high density interconnect packages, dielectrics and liquid crystal display (LCD) element orienting films in flat panel displays, as stress buffers on integrated circuits, as thin magnetic head insulating films, and for lift-off processing. The patterning of nonphotosensitive polymers for these applications requires the use of organic photoresists to serve as etch templates to transfer the image from the photomask to the polyimide. This indirect method of patterning the polymer is complicated by the processing steps required for applying, drying, patterning, and stripping the photoresist and/or hard mask. Photosensitive polymers, which can be patterned directly, reduce the number of processing steps by eliminating the need for photoresists and/or hard masks resulting in increased device yield and throughput as well as a cost savings to the manufacturer.

Examples of photosensitive polymer compositions useful for forming relief structures on electrical devices are well known as shown in Sigusch et al. U.S. Patent No. 3,953,877, Kleeberg et al. U.S. Patent No. 3,957,512, Rubner et al. U.S. Patent No. Re. 30,186, Goff et al. U.S. Patent No. 4,329,419, Goff et al. U.S. Patent No. 4,414,312, Goff U.S. Patent No. 4,416,973, Goff U.S. Patent No. 4,430,418, and Fryd et al. U.S. Patent No. 4,551,522. A typical process for producing relief structures from these photosensitive compositions consists of the following steps as disclosed by Goff et al. in U.S. Patent No. 4,369,247:

(1) An adhesion promoter solution is applied to the substrate.

(2) A solution of the composition is applied to the substrate.

(3) The solvent is evaporated to yield a coated film of the photosensitive composition.

(4) The film is exposed to radiation through a photomask. The exposed portions of the film are polymerized to form a crosslinked intermediate.

(5) The unexposed and uncrosslinked part of the film is removed by dissolution in a developer solution. The remaining film is then washed with a rinse solution to yield a relief structure.

(6) The remaining film is heated to convert it to a polyimide or other thermally stable structure.

Conventional developer solutions used in the patterning of these photosensitive compositions consist either of a good solvent for the polymer, for example a developer solution of dimethylacetamide alone, or a mixture of a good solvent and a poor solvent for the polymer, for example a 1:1 (w/w) mixture of 4-butyrolactone and xylene. Control of the development process using these developer solutions is often hampered by changes in relative humidity. As the relative humidity changes, the rate of dissolution of the exposed polymer in the developer solution varies. This can lead to overdevelopment or underdevelopment since the range of acceptable development times with these developer solutions is narrow. These developer solutions also swell the exposed portions of the film leading to poor pattern resolution. In worst cases, the bridging of closely spaced lines or features can occur. The quality of these developer solutions can change with time due to, for example, the volatile loss of one developer solvent component or moisture adsorption. This can also lead to overdevelopment or underdevelopment. In addition, because of the high content of poor solvent, often a highly volatile solvent, these developer solutions are flammable and toxic, presenting disposal problems.

Japanese patent application Kokai No. 62-269955 discloses a pattern forming method in which a photocrosslinking polymer having a repeating unit of formula (I) is developed with a solution containing more than 1 vol% but less than 8 vol% of water and/or more than 1 vol% but less than 50 vol% of an alcohol of up to two carbon atoms. Formula (I) is as follows:

$$\begin{array}{cccccccc} - & \underset{\underset{(COOR)_n}{|}}{X} & - & Z & - & \underset{\underset{(W)_m}{|}}{Y} & - & Z & - \end{array} \qquad (I)$$

in which X is a (2+n) valent carbon cyclic group or heterocyclic group; Y is a (2+m) valent carbon cyclic

group or heterocyclic group; Z is -CO-NH-, -NH-CO-NH-, or -O-CO-NH-; R is a group having a carbon-carbon double bond; W is a group which forms a ring by reaction with a carbonyl group of -COOR by heat treatment; n is 1 or 2; m is 0,1, or 2; and COOR and Z are mutually in an ortho or para position relationship. This method overcomes some of the humidity sensitivity problems but there is still room for improvement. For example, if the water and/or two carbon atom alcohol content of the developer is outside of the recited ranges, development is impossible or takes an extremely long time, the residue of development increases, and swelling of exposed portions and pattern dullness is pronounced, according to page 10 of the reference.

## SUMMARY OF THE INVENTION

The invention is directed to a radiation polymerizable composition that can be developed in an aqueous developer solution containing at least about 1% by weight water, the radiation polymerizable composition comprising

(a) about 5-75% by weight, based on the weight of the composition, of a partially esterified, aromatic polyamic acid resin wherein the ester groups contain a photoreactive moiety,

(b) about 95-25% by weight, based on the weight of the composition, of solvent or a mixture of solvents capable of dissolving the compostion,

(c) about 0.01-20% by weight with respect to the resin, of a photopolymerization initiator or a mixture of photopolymerization initiators, and

(d) an adhesion promoter.

The invention is further directed to a method for forming a polyimide relief pattern on a substrate comprising the steps of applying to the substrate a radiation polymerizable composition comprising

(a) about 5-75% by weight, based on the weight of the composition, of a partially esterified, aromatic polyamic acid resin wherein the ester groups contain a photoreactive moiety,

(b) about 95-25% by weight, based on the weight of the composition, of solvent or a mixture of solvents capable of dissolving the compostion,

(c) 0.01-20% by weight with respect to the resin, of a photopolymerization initiator or a mixture of photopolymerization initiators, and

(d) an adhesion promoter; exposing the composition to radiation through a pattern; applying to the radiated composition an aqueous developer solution containing at least about 1% by weight water to remove the unradiated portions of the composition; and curing the resulting relief pattern to convert the polyamic acid resin to polyimide.

And, the invention is directed to an electrical device comprising a polyimide relief pattern on a substrate formed by a method comprising the steps of: applying to the substrate the radiation polymerizable composition described above; exposing the composition to radiation through a pattern; applying to the radiated composition an aqueous developer solution containing at least about 1% by weight water to remove the unradiated portions of the composition; and curing the resulting relief pattern to convert the polyamic acid resin to polyimide.

## DESCRIPTION OF THE INVENTION

To overcome the problems listed above, a photosensitive composition that can be developed using an aqueous developer solution was invented. The use of an aqueous developer reduces the humidity sensitivity of the development process, decreases the amount of swelling of the exposed part of the resin, and lowers both the toxicity and flammability of the developer solution compared to a developer solution without the water. Another advantage is that aqueous developers can be used in positive photoresist development equipment. In addition, developer solutions containing water present fewer disposal problems compared to nonaqueous developer solutions. Aqueous solutions can often be disposed of in standard chemical sewers. This can result in a considerable cost savings compared to the cost of drumming up the waste solution for incineration or offsite disposal.

About 5-75% by weight of the radiation polymerizable composition of the invention comprises a partially esterified, aromatic polyamic acid resin wherein the ester groups contain a photoreactive moiety such as an olefinic double bond. Polyamic acids can be characterized by a repeating unit of the general formula:

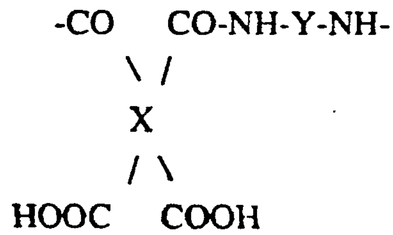

wherein X is an aromatic organic radical and Y is an organic radical. These polyamic acids can be produced by reacting aromatic polycarboxylic acid anhydrides with diamines. Suitable aromatic polycarboxylic acid anhydrides and diamines are disclosed in Edwards et al. U.S. Patent No. 3,179,614 which disclosure is herein incorporated by reference.

Partially esterified resins can be prepared by a variety of routes known in the art. The ester group must contain a photoreactive moiety. A photoreactive moiety is one which upon irradiation undergoes chemical transformation such as polymerization or deterioration. Examples of photoreactive moieties include carbonyl, nitro, nitroso, diazo, and unsaturated organic moieties, such as acetylenes.

Particularly preferred polyamide ester resins have the following structure:

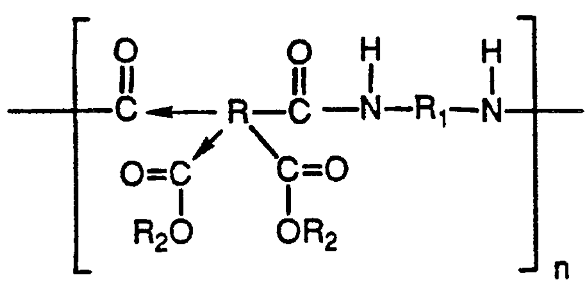

wherein → denotes isomerism, R is an aromatic radical, $R_1$ is an aliphatic, aromatic, or cycloaliphatic radical, and each $R_2$ is independently selected from the group consisting of a hydrogen radical and an organic radical containing a photopolymerizable olefinic double bond, about 5-80 % of the $R_2$ substituents being hydrogen, and n is a positive integer sufficiently large to provide the resin with a number average molecular weight of about 1,000 to 75,000.

Any organic radical containing a photopolymerizable olefinic double bond may be used as an $R_2$ substituent. Examples of such groups which may be included in the $R_2$ organic radical are vinyl, allyl, acryl, methacryl, cinnamyl, maleimido, and so on. Hydroxy alkyl methacrylate or hydroxy alkyl acrylate groups such as hydroxethyl acrylate, hydroxypropyl acrylate, hydroxybutyl acrylate, hydroxyethyl methacrylate, hydroxypropyl methacrylate, hydroxybutyl methacrylate and polyfunctional acrylates such as pentaerythritol triacrylate are also suitable olefinic photopolymerizable groups.

Preferrably, about 5-80 % of the $R_2$ substituents are hydrogen. More preferrably, about 10-80 % of the $R_2$ substituents are hydrogen.

The most preferred partially esterified, aromatic polyamide ester resins are the reaction products of benzophenone tetracarboxylic dianhydride, hydroxyethyl methacrylate, oxydianiline, and metaphenylene diamine, and the reaction product of biphenyl dianhydride, hydroxyethyl methacrylate, and paraphenylene diamine.

About 95-25% by weight of the radiation polymerizable composition of the invention comprises a solvent or mixture of solvents. Examples of solvents that are capable of dissolving all of she constituents of the photosensitive composition of the invention include dimethylformamide, dimethylacetamide, N-methylpyrrolidone, 4-butyrolactone, ethylene glycol monoethyl ether, hexamethylphosphoric acid triamide, dimethylsulfoxide, cyclopentanone, and diglyme. Solvents such as these which are capable of dissolving the constituents of the composition may be used alone or in combination with other solvents (for example alcohols, ketones, ethers, aromatic hydrocarbons, etc.) provided the mixture of solvents completely dissolves all of the constituents of the photosensitive composition.

The photosensitive composition of the invention also comprises about 0.01-20% by weight, based on the resin, of a photopolymerization initiator or a mixture thereof. Examples of suitable photopolymerization initiators are aromatic biimidazole intiators as disclosed by Chambers, U.S. Patent No. 3,479,185, Chang, U.

S. Patent No. 3,459,367, Fishman, U.S. Patent No. 3,552,973, and Cescon, U.S. Patent No. 3,784,557 herein incorporated by reference, quinones, aromatic ketones as disclosed in the aforementioned U.S. Patent No. 3,552,973, and benzoins, benzophenones, and mixtures thereof. A 2,4,5-triarylimidazolyl dimer having an ortho substituent on the 2 phenyl ring is a particularly useful initiator. Examples of initiators of this type are 2-o-chlorophenyl-4,5-diphenylimidazolyl dimer, 2-o-fluorophenyl-4,5-diphenylimidazolyl dimer, 2-o-methoxyphenyl-4,5-diphenylimidazolyl dimer, 2-o-ethoxyphenyl-4,5-diphenylimidazolyl dimer, and mixtures thereof. Particularly preferred are bis(2-o-chlorophenyl-4,5-diphenyl) imidazole and bis[2-o-chlorophenyl-4,5-di(m-methoxyphenyl)] imidazole.

An adhesion promoter is added to the photosensitive composition of the invention to improve adhesion between the photopolymerizable resin and the substrate to which it is applied. Suitable adhesion promoters are the polyfunctional alkoxysilane compounds disclosed by Merriman et al. in copending U.S. Patent Application Serial No. 07/088,142, filed August 21,1987, which is herein incorporated by reference. The reaction products of these polyfunctional alkoxysilane compounds and water can also be used as adhesion promoters. It is believed that reaction of the polyfunctional alkoxysilane compounds with water hydrolyzes some or all of the alkoxysilane groups thereby converting them into hydroxysilane groups which further improve adhesion between the substrate and the resin. The quantity of adhesion promoter is usually about 0.01-20% by weight, based on the resin. (3-(triethoxysilyl)propyl)urea and the reaction product of (3-(triethoxysilyl)propyl)urea and water are preferred adhesion promoters. In one method for producing this reaction product 32.60 grams of N-(triethoxysilyl)propyl)urea, 63.28 grams of methaniol, 11.17 grams of distilled water, and 1.92 grams of trifluoracetic acid are charged into a 250 ml. round bottomed flask with magnetic stirrer. The mixture is stirred for about 2 hours at about 25°C. About 25 ml. of N-methyl-2-pyrrolidone is added and the volatiles removed under reduced pressure with slight warming (about 50°C.) The residue is transferred to a clean container and diluted to 55.56 grams total with N-methyl-2-pyrrolidone thereby producing a 20 wt. % solution of hydrolyzed (3-(triethoxysilyl)propyl)urea.

In addition to the foregoing, the composition of the invention may also include any combination of the following: a radiation polymerizable polyfunctional acrylate compound or a mixture of polyfunctional acrylate compounds; a chain transfer agent or a mixture of chain transfer agents; oxygen scavengers; a sensitizer or a mixture of sensitizers; or polymerization inhibitors.

Radiation polymerizable polyfunctional acrylates and mixtures thereof reduce exposure times and increase the rate of photopolymerization of the resin. Typical examples of radiation polymerizable polyfunctional acrylate compounds include: trimethylolpropane trimethacrylate, trimethylolpropane triacrylate, trimethylolpropane tetraacrylate, trimethylolpropane ethoxy trimethacrylate, trimethylolpropane ethoxy triacrylate, trimethylolpropane polyethoxylate trimethacrylate, trimethylolpropane polyethoxylate triacrylate, tetramethylolmethane tetraacrylate, 2-ethylhexyl acrylate, 2-hydroxyethyl acrylate, 2-hydroxyethyl methacrylate, N-vinyl-2-pyrrolidone, carbitol acrylate, tetrahydrofurfuryl acrylate, isobornyl acrylate, 1,6-hexanediol diacrylate, neopentyl glycol diacrylate, ethylene glycol diacrylate, polyethylene glycol diacrylate, tripropylene glycol diacrylate, tetraethylene glycol diacrylate, pentaerythritol diacrylate, pentaerythritol triacrylate, pentaerythritol tetraacrylate, dipentaerythritol hexaacrylate, nonaethylene glycol diacrylate, and mixtures thereof. Some preferred polyfunctional acrylate compounds that produce high quality compositions include tetraethylene glycol diacrylate, trimethylolpropane triacrylate, and trimethylolpropane ethoxy triacrylate. The quantity of radiation polymerizable polyfunctional acrylates and mixtures thereof, if added, is usually about 10-50% by weight, based on the resin.

Chain transfer agents may be added to increase the photospeed of the composition. Examples of chain transfer agents are mercaptoimidazoles, mercaptobenzimidazoles, mercaptothiazoles, mercaptobenzothiazoles, mercaptobenzoxazoles as disclosed in Chambers, U.S. Patent No. 4,291,115, mercaptotetrazoles, N-phenyl glycine, triphenylphosphine, and mixtures thereof. Particularly useful are 2-mercaptobenzoxazole and N-phenyl glycine. The quantity of the chain transfer agent, if added, is usually about 0.01-10% by weight, based on the resin.

Oxygen scavengers may also be added to increase the photospeed of the composition. Oxygen scavengers that have been found to be useful are phosphines, phosphonates, phosphites, stannous salts, and other compounds that are easily oxidized by oxygen. Some oxygen scavengers may also act as chain transfer agents. The quantity of the oxygen scavenger, if added, is usually about 0.01-10% by weight, based on the resin.

The photosensitivity and photospeed of the composition can also be improved by the addition of sensitizers with a peak absorbance in the range of 200-500 nm. The quantity of sensitizer, if added, is usually about 0.01-20% by weight, based on the resin. Examples of sensitizers include p-aminophenyl ketones as disclosed by Chang, U.S. Patent No. 3,549,367 which is hereby incorporated by reference, bis-(p-dialkylaminobenzylidene) ketones as disclosed by Baum and Henry U.S. Patent No. 3,652,275 which is

herein incorporated by reference, derivatives of aryl ketones and p-dialkylaminoarylaldehydes as disclosed by Dueber U.S. Patent No. 4,162,162 which is herein incorporated by reference, N-alkylindolylidenes or N-alkylbenzothiazolylidene alkanones as disclosed by Dueber at al. U.S. Patent No. 4,454,218 which is herein incorporated by reference, and constrained N-alkylamino aryl ketones as disclosed by Anderson et al. U.S. Patent No. 4,535,052 which is herein incorporated by reference.

Polymerization inhibitors may be added to the composition to improve the storage stability of the composition. Examples of polymerization inhibitors include hydroquinone, N-nitrosodiphenylamine, 1,4,4-trimethyl-2,3-diazabicyclo(3.2.2)non-2-ene,2,3-dioxide as disclosed in U.S. Patent No. 4,168,982, phenyl pyrazilidinones, and tetramethyldiphenyl quinone as disclosed in U.S. Patent No. 4,168,982 and mixtures thereof. The quantity of polymerization inhibitors, if added, is usually about 0.01-10% by weight, based on the resin.

In the process for applying the radiation polymerizable composition of the invention to substrates, the composition is applied and then dried to form a film at about 30°-100°C. for about 20 minutes to 5 hours, depending upon the coating thickness. The film is then exposed to actinic radiation through a pattern for about 1 second to 5 minutes. Preferably, for a commercial process exposure times of 1-60 seconds are required and usually an exposure time under 30 seconds is much preferred. Typical radiation sources used are ultraviolet lamps providing a wave length of 250 to 500 nanometers and an intensity of 0.5- 60 milliwatts per square centimeter (mW/cm$^2$). After exposure, the film is treated with a developer solution.

The developer solution can be a conventional solution known in the art or an aqueous solution comprising water and etchant. Examples of conventional developer solutions include dimethylacetamide, 4-butyrolactone or N-methyl-2-pyrrolidone or any combination thereof with xylene, cyclohexanone or cyclopentanone or any combination thereof.

An etchant is a substance that will remove by dissolution or by acid-base reaction the unexposed portions of the coated film. Examples of good etchants include dimethyl formamide, dimethyl acetamide, cyclopentanone, cyclohexanone, N-methylpyrrolidone, 4-butyrolactone, ethylene glycol monoethyl ether, dimethylsulfoxide, hexamethylphosphoric acid triamide, butyl Carbitol® (diethylene glycol butyl ether), DBE (dibasic acid ethyl esters of succinic, glutaric and adipic acids), and tetrahydrofuran and salts of the following: metal hydroxides, alkylammonium hydroxides, metal bicarbonates, phosphates, and amines. Good etchants can be used alone or in combination as mixtures of two or more.

A poor etchant is a substance that will not completely remove the unexposed portions of the coated film. Examples of poor etchants include: toluene, xylene, ethylbenzene, isopropylbenzene, acetone, methyl ethyl ketone, methyl Cellosolve®, ethyl Cellosolve®, isopropyl Cellosolve®, methanol, ethanol, n-propanol, isopropanol, and isobutanol. A single poor etchant or a mixture of poor etchants may be used in combination with a good ethant or mixture of good etchants. There are no special restrictions on the mixing ratios of the poor etchants relative to the good etchants as long as the developer solutions remove the unexposed portions of the films after the addition of water.

Aqueous developer solution water content may be at least about 1% by weight, preferrably at least about 5%, and more preferrably at least about 10%.

The developer solution can be applied to the film by spray, immersion or ultrasonic means. The best resolution can be obtained by spray development.

The rate of development can be increased by increasing the temperature of the developer solution. Typically, the development temperature is in the range of about 20 - 50°C.

After development, the film is washed with a rinse solution in order to remove the developer solution and stop the development process. The developer and rinse solutions may be briefly overlapped to provide a controlled deswelling of the exposed portions of the film. Examples of rinse solvents include acetone, methyl ethyl ketone, ethylene glycol monomethyl ether, glycol ethyl ether, methanol, ethanol, n-propyl alcohol, isopropyl alcohol, toluene, xylene, ethylbenzene, and water. The rinse solvents can be used alone or in combination as mixtures of two or more. The preferred rinse solvent is water.

Following treatment with the rinse solution, the film is dried and cured to a polyimide relief structure by baking at about 150-500°C. for about 20 minutes to 8 hours. During curing, the carboxylic acid and ester groups react with the amide groups to form the polyimide. The resulting relief structure has a sharp definition, as well as good chemical, electrical and mechanical properties.

The following examples illustrate the invention. All parts and percentages are on a weight basis, unless otherwise specified.

| Example 1 | |
|---|---|
| Ingredients | Grams |
| Polyamide ester resin (polymer of benzophenone tetracarboxylic dianhydride esterified with hydroxy ethyl methacrylate and reacted with 4,4′-oxydianiline and 1,3-phenylene diamine) | 20.00 |
| Tetraethylene glycol diacrylate | 3.00 |
| Bis(2-o-chlorophenyl-4,5-diphenyl) imidazole | 1.20 |
| 2-Mercaptobenzoxazole | 0.40 |
| 4,4′-(Diethylamino)benzophenone | 0.60 |
| N-(3-(Triethoxysilyl)propyl)butenedioamic acid | 0.20 |
| 1,4,4-Trimethy-2,3-diazabicyclo(3.2.2)non-2-ene | 0.03 |
| 4-Butyrolactone | 24.63 |
| Acetone | 1.35 |
| Total: | 51.41 |

The 4-butyrolactone and acetone are charged into a container in a chilled water bath and stirred until mixed. The polyamide ester resin is added slowly and stirred until dissolved. The remaining ingredients are then added and stirred until dissolved. The resulting composition is filtered through a 0.5 micron filter to yield composition C-1.

Examples 2 - 4

These examples illustrate the preparation and exposure of other photopolymerizable compositions. The same operation described in Example 1 is used with the ingredients listed in Table 1.

Table 1

| | Composition (grams) | | |
|---|---|---|---|
| Ingredients | C-2 | C-3 | C-4 |
| Polyamide ester resin of Example 1 | - | 20.00 | 20.00 |
| Polyamide ester resin (polymer of biphenyl dianhydride esterified with hydroxy ethyl methacrylate and reacted with 1,4-phenylene diamine) | 20.00 | - | - |
| Tetraethylene glycol diacrylate | 3.45 | 6.00 | 3.00 |
| Trimethylolpropane ethoxy triacrylate | - | - | 4.25 |
| Bis(2-o-chlorophenyl-4,5-diphenyl) imidazole | 1.20 | 1.20 | 1.20 |
| 2-Mercaptobenzoxazole | 0.40 | - | - |
| N-Phenyl glycine | - | 0.40 | 0.80 |
| 4,4′-(Diethylamino)benzophenone | 0.60 | 0.60 | 0.60 |
| 1,4,4-Trimethy-2,3-diazabicyclo(3.2.2)non-2-ene | 0.03 | 0.03 | - |
| 1-Phenyl-3-pyrazolidinone | - | - | 0.03 |
| N-(3-(Triethoxysilyl)propyl)butenedioamic acid | 0.20 | 0.20 | - |
| 4-Butyrolactone | - | 24.63 | 24.63 |
| Acetone | - | 1.35 | 1.35 |
| N-Methyl-2-pyrrolidone | 37.97 | - | - |
| Total | 63.85 | 54.41 | 55.86 |

Application Example 1

A 3 inch silicon wafer having a silicon dioxide coating is held at 300 °C. for 30 minutes to remove moisture then cooled to room temperature. Composition C-1 is applied to the wafer by a spin coating technique wherein the wafer is rotated at 3000 rpm for 30 seconds. The coating of the composition is dried in air for 45 - 60 minutes at 55 °C in a convection oven. The coated wafer is cooled to room temperature and placed in a contact printer having a 500 watt ultraviolet light source and an intensity of 20 $mW/cm^2$ measured at 365 nm. The coated wafer is exposed through a mask with lines spaced 4 microns apart for 12 seconds. The wafer is then spray developed while spinning at 2000 rpm with an 80/20 (w/w) mixture of 4-butyrolactone/water for 20 seconds and rinsed for 15 seconds with water to remove any unexposed composition. The developed wafer is heated and held at 450 °C for 1 hour to provide a polyimide relief structure having a clear definition of an electrical circuit about 3 microns thick. The fully cured coating can be exposed to temperatures in excess of 500 °C with no loss of relief structure features.

Application Examples 2-13

Application Example 1 was repeated with varying exposure time, developing method, developer temperature, developer solution composition, and develop time. In all cases, the rinse solution is water.

Table 2

| Application Example Number | Composition | Film Thickness (μm) | Exposure Time (sec) | Developing Method & Temperature (° C) | Developer Solution (weight ratio) | Develop Time (sec) |
|---|---|---|---|---|---|---|
| 1 | C-1 | 3 | 12 | Spray (21° C) | 4-butyrolactone/water (80/20) | 15.0 |
| 2 | C-1 | 3 | 12 | Spray (21° C) | 4-butyrolactone/water (90/10) | 12.5 |
| 3 | C-1 | 3 | 12 | Spray (21° C) | N-methyl-2-pyrrolidone/water (90/10) | 13.0 |
| 4 | C-1 | 3 | 12 | Spray (21° C) | 4-butyolactone/isopropyl alcohol/water (50/40/10) | 21.0 |
| 5 | C-1 | 3 | 25 | Immersion (21° C) | 0.25N KOH solution containing 10% (wt) butyl Carbitol® | 60.0 |
| 6 | C-1 | 3 | 25 | Immersion (21° C) | 0.5N KOH solution | 90.0 |
| 7 | C-1 | 3 | 25 | Immersion (21° C) | 0.5N KOH solution | 12.0 |
| 8 | C-1 | 3 | 25 | Immersion (21° C) | 0.5N tetramethylammonium hydroxide solution | 20.0 |
| 9 | C-1 | 3 | 25 | Immersion (21° C) | 0.25N tetramethylammonium hydroxide solution containg 17% (wt) butyl Carbitol® | 10.0 |
| 10 | C-2 | 3 | 12 | Spray (21° C) | 4-butyrolactone/water (80/20) | 15.0 |
| 11 | C-2 | 3 | 12 | Spray (21° C) | 4-butyrolactone/water (90/10) | 12.5 |
| 12 | C-3 | 3 | 12 | Spray (21° C) | 4-butyrolactone/water (80/20) | 9.5 |
| 13 | C-4 | 3 | 12 | Spray (21° C) | 4-butyrolactone/water (80/20) | 6.0 |

Comparative Example 1

Composition C-1 was developed using a 50/50 (w/w) mixture of 4-butyrolactone/xylene with a xylene rinse solution. Table 3 shows the change in development rate in mg/second as a function of relative humidity at 25° C with a 50/50 (w/w) mixture of 4-butyrolactone and xylene and a xylene rinse compared to an 80/20 (w/w) and a 90/10 (w/w) mixture of 4-butyrolactone/water and a water rinse.

Table 3

| Humidity | 4-butyrolactone/xylene (50/50) | 4-butyrolactone/water (80/20) | 4-butyrolactone/water (90/10) |
|---|---|---|---|
| 30% | 1.9 mg./sec. | 3.8 mg./sec. | 4.7 mg./sec. |
| 50% | 3.0 mg./sec. | 4.0 mg./sec. | 4.9 mg./sec. |

Comparative Example 2

A 3 inch silicon wafer having a silicon dioxide coating is held at 300° C for 30 minutes to remove moisture then cooled to room temperature. Composition C-2 is applied to the wafer by a spin coating technique wherein the wafer is rotated at 3000 rpm for 30 seconds. The coating of the composition is dried in air for 60 minutes at 55° C in a convection oven. The coated wafer is cooled to room temperature and placed in a contact printer having a 500 watt ultraviolet light source and an intensity of 20 $mW/cm^2$ measured at 365 nm. The coated wafer is exposed through a mask with lines spaced 4 microns apart for 12 seconds. The wafer is then spray developed while spinning at 2000 rpm with an 90/10 (w/w) mixture of 4-butyrolactone/xylene for 30 seconds and rinsed for 15 seconds with xylene. The unexposed portions of the coated film could not be removed.

## Claims

1. A radiation polymerizable composition that can be developed in an aqueous developer solution containing at least about 1% by weight water, the radiation polymeriZable composition comprising
(a) about 5-75% by weight, based on the weight of the composition, of a partially Esterified, aromatic polyamlc acid resin wherein the ester groups contain a photoreactive moiety,
(b) about 95-25% by weight, based on the weight of the composition, of solvent or a mixture of solvents capable of dissolving the compostion,
(c) 0.01-20% by weight with respect to the resin, of a photopolymerization initiator or a mixture of photopolymerization initiators,
(d) an adhesion promoter;
provided the composition does not consist essentially of (a) a polyamic acid resin which is a polymer of benzophenone tetracarboxylic dianhydride esterified with hydroxyethyl methacrylate and reacted with 4,4'-oxydianiline and 1,3-phenylene diamine, (b) 4-butyrolactone/acetone, (c) bis(2-o-chlorophenyl-4,5-diphenyl) imidazole, and (d) N-(3-(triethoxysilyl)propyl)butenedioamic acid.
2. The composition of claim 1 wherein the partially esterified, aromatic polyamic acid resin comprises the formula:

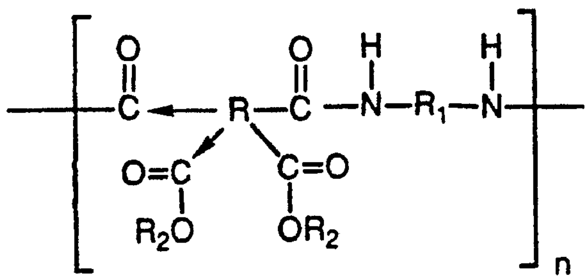

wherein → denotes isomerism, each R is an aromatic radical, each $R_1$ is an aliphatic, aromatic, or cycloaliphatic radical, and each $R_2$ is independently selected from the group consisting of a hydrogen radical and an organic radical containing a photopolymerizable olefinic double bond, about 5-80 % of the $R_2$ substituents being hydrogen, and n is a positive integer sufficiently large to provide the resin with a number average molecular weight of about 1,000 to 75,000.

3. The composition of claim 2 wherein the adhesion promoter is selected from the group consisting of polyfunctional alkoxysilane compounds, reaction products of polyfunctional alkoxysilane compounds and water, and mixtures thereof.

4. The composition of claim 3 wherein the adhesion promoter is selected from the group consisting of (3-(triethoxysilyl)propyl)urea and the reaction product of (3-(triethoxysilyl)propyl)urea and water.

5. The composition of claim 2 wherein each $R_2$ is independently selected from the group consisting of hydroxy $C_{1-8}$ alkyl methacrylate, hydroxy $C_{1-8}$ alkyl acrylate, and hydrogen.

6. The composition of claim 5 wherein each R is selected from the group consisting of phenyl, benzophenone, and biphenyl.

7. The composition of claim 6 wherein each $R_1$ is selected from the group consisting of phenoxyphenyl and phenylene.

8. The composition of claim 7 wherein the adhesion promoter is selected from the group consisting of polyfunctional alkoxysilane compounds, reaction products of polyfunctional alkoxysilane compounds and water, and mixtures thereof.

9. The composition of claim 8 wherein the adhesion promoter is selected from the group consisting of (3-(triethoxysilyl)propyl)urea and the reaction product of (3-(triethoxysilyl)propyl)urea and water.

10. The composition of claim 9 further comprising 10-50% by weight, based on the resin, of a radiation polymerizable polyfunctional acrylate compound or a mixture of polyfunctional acrylate compounds.

11. A method for forming a polyimide relief pattern on a substrate comprising the steps of:

applying to the substrate a radiation polymerizable composition comprising

(a) about 5-75% by weight, based on the weight of the composition, of a partially esterified, aromatic polyamic acid resin wherein the ester groups contain a photoreactive moiety,

(b) about 95-25% by weight, based on the weight of the composition, of solvent or a mixture of solvents capable of dissolving the compostion,

(c) 0.01-20% by weight with respect to the resin, of a photopolymerization initiator or a mixture of photopolymerization initiators;

exposing the composition to radiation through a pattern;

applying to the radiated composition an aqueous developer solution containing at least about 1% by weight water to remove the unradiated portions of the composition; and

curing the resulting relief pattern to convert the polyamic acid resin to polyimide.

12. The method of claim 11 wherein the partially esterified, aromatic polyamic acid resin comprises the formula:

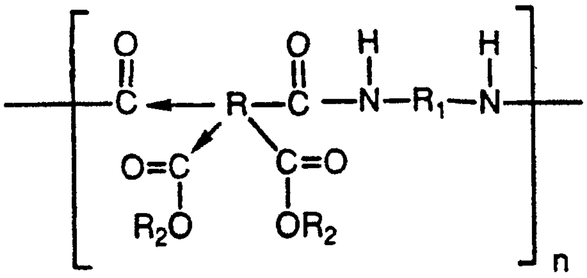

wherein → denotes isomerism, each R is an aromatic radical, each $R_1$ is an aliphatic, aromatic, or cycloaliphatic radical, and each $R_2$ is independently selected from the group consisting of a hydrogen radical and an organic radical containing an olefinic photopolymerizable group, about 5-80 % of the $R_2$ substituents being hydrogen, and n is a positive integer sufficiently large to provide the resin with a number average molecular weight of about 1,000 to 75,000.

13. The method of claim 12 wherein each $R_2$ is independently selected from the group consisting of hydroxy $C_{1-8}$ alkyl methacrylate, hydroxy $C_{1-8}$ alkyl acrylate, and hydrogen.

14. The method of claim 13 wherein each R is selected from the group consisting of phenyl, benzophenone, and biphenyl.

15. The method of claim 14 wherein each $R_1$ is selected from the group consisting of phenoxyphenyl and phenylene.

16. The method of claim 11 wherein the developer solution comprises about 1-50 % by weight water and 99-50 % by weight 4-butyrolactone, N-methylpyrrolidone, isopropanol, potassium hydroxide, tetramethylammonium hydroxide, diethylene glycol butyl ether or any mixture thereof.

17. The method of claim 16 wherein the developer solution comprises about 10-50 % by weight water.

18. The method of claim 12 wherein the developer solution comprises about 1-50 % by weight water and 99-50 % by weight butyrolactone, N-methylpyrrolidone, isopropanol, potassium hydroxide, tetramethylammonium hydroxide, diethylene glycol butyl ether or any mixture thereof.

19. The method of claim 18 wherein the developer solution comprises about 10-50 % by weight water.

20. The method of claim 15 wherein the developer solution comprises about 1-50 % by weight water and 99-50 % by weight 4-butyrolactone, N-methylpyrrolidone, isopropanol, potassium hydroxide, tetramethylammonium hydroxide, diethylene glycol butyl ether or any mixture thereof.

21. The method of claim 20 wherein the developer solution comprises about 10-50 % by weight water.

22. An electrical device comprising a polyimide relief pattern on a substrate formed by a method comprising the steps of:

applying to the substrate a radiation polymerizable composition comprising

(a) about 5-75% by weight, based on the weight of the composition, of a partially esterified, aromatic polyamic acid resin wherein the ester groups contain a photoreactive moiety,

(b) about 95-25% by weight, based on the weight of the composition, of solvent or a mixture of solvents capable of dissolving the compostion,

(c) 0.01-20% by weight with respect to the resin, of a photopolymerization initiator or a mixture of photopolymerization initiators;

exposing the composition to radiation through a pattern;

applying to the radiated composition an aqueous developer solution containing at least about 1% by weight water to remove the unradiated portions of the composition; and

curing the resulting relief pattern to convert the polyamic acid resin to polyimide.

23. The electrical device of claim 22 wherein the partially esterified, aromatic polyamic acid resin of the radiation polymerizable composition comprises the formula:

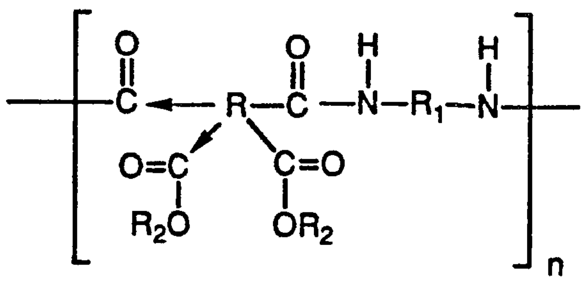

wherein → denotes isomerism, each R is an aromatic radical, each $R_1$ is an aliphatic, aromatic, or cycloaliphatic radical, and each $R_2$ is independently selected from the group consisting of a hydrogen radical and an organic radical containing a photopolymerizable olefinic double bond, about 5-80 % of the $R_2$ substituents being hydrogen, and n is a positive integer sufficiently large to provide the resin with a number average molecular weight of about 1,000 to 75,000.

24. The electrical device of claim 23 wherein each $R_2$ is independently selected from the group consisting of hydroxy $C_{1-8}$ alkyl methacrylate, hydroxy $C_{1-8}$ alkyl acrylate, and hydrogen.

25. The electrical device of claim 24 wherein each R is selected from the group consisting of phenyl, benzophenone, and biphenyl.

26. The electrical device of claim 25 wherein each $R_1$ is selected from the group consisting of phenoxyphenyl and phenylene.

27. The electrical device of claim 26 wherein the radiation polymerizable ccmposition further comprises 10-50% by weight, based on the resin, of a radiation polymerizable polyfunctional acrylate compound or a mixture of polyfunctional acrylate compounds.